(19) **Europäisches Patentamt**
**European Patent Office**
**Office européen des brevets**

(11) **EP 3 486 665 B1**

(12) **EUROPEAN PATENT SPECIFICATION**

(45) Date of publication and mention
of the grant of the patent:
**20.04.2022 Bulletin 2022/16**

(21) Application number: **18206205.9**

(22) Date of filing: **14.11.2018**

(51) International Patent Classification (IPC):
**G01R 19/25** *(2006.01)*   **G01R 21/133** *(2006.01)*
**G01R 23/16** *(2006.01)*   **G01R 15/18** *(2006.01)*
**G01R 15/14** *(2006.01)*   **G01R 21/00** *(2006.01)*
**G01R 21/06** *(2006.01)*

(52) Cooperative Patent Classification (CPC):
**G01R 21/1331; G01R 15/142; G01R 15/183;**
**G01R 19/25; G01R 21/002; G01R 21/06;**
**G01R 21/1333; G01R 23/16**

(54) **REMOTE MEASUREMENT OF ELECTRICAL ACTIVE POWER**

FERNMESSUNG DER ELEKTRISCHEN WIRKLEISTUNG

MESURE À DISTANCE DE PUISSANCE ACTIVE ÉLECTRIQUE

(84) Designated Contracting States:
**AL AT BE BG CH CY CZ DE DK EE ES FI FR GR**
**HR HU IE IS IT LI LT LU LV MC MK MT NL NO PL**
**PT RO RS SE SI SK SM TR**

(30) Priority: **16.11.2017 GB 201718943**

(43) Date of publication of application:
**22.05.2019 Bulletin 2019/21**

(73) Proprietor: **Myenergi Ltd**
**Stallingborough, Lincolnshire DN41 8FF (GB)**

(72) Inventors:
• **SUTTON, Lee Robert**
**MARKET RASEN, LN8 6DF (GB)**
• **RICHARD, Robin**
**GRIMSBY, DN32 0LB (GB)**

(74) Representative: **Dehns**
**St. Bride's House**
**10 Salisbury Square**
**London EC4Y 8JD (GB)**

(56) References cited:
EP-A1- 3 054 303    WO-A1-2013/121628
CN-A- 106 199 170   CN-A- 107 219 432
US-A1- 2006 129 339  US-A1- 2007 059 986
US-A1- 2009 309 754  US-A1- 2010 301 837
US-A1- 2012 302 182  US-A1- 2014 028 282
US-A1- 2017 030 952

• VALCHEV V C ET AL: "Self powered current
acquisition system with wireless data transfer",
2013 36TH INTERNATIONAL CONVENTION ON
INFORMATION AND COMMUNICATION
TECHNOLOGY, ELECTRONICS AND
MICROELECTRONICS (MIPRO), MIPRO, 20 May
2013 (2013-05-20), pages 108-112, XP032482818,
[retrieved on 2013-09-11]

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

## Description

## Field of the Invention

This invention relates to a system for remotely measuring the active power flowing through an electrical conductor from an alternating current source to a load.

## Background to the Invention

In a household with grid-tied on-site generation, the electrical supply to the property from the utility grid can have reverse current flow; the utility grid becomes the load to the on-site generator. In order to measure the power consumption of the house and the exported power to the utility grid, the active power must be measured.

It is desirable to be able to install a power measurement system without making electrical contact with the conductors, since this simplifies installation and permits it to be done without the need for electrical isolation first. It is further desirable to obtain the power measurement remotely as this eliminates potentially difficult to install cable runs. Remote measurement requires a transmitter and a receiver and usually both would require a power source. Sometimes it can be impractical to connect to a power source at the measurement point, (for example, in a household electrical meter box where there is no adjacent consumer unit) and the use of batteries would necessitate continuous maintenance.

Current transformers are often used to measure the alternating current flowing in a conductor without electrical contact with the conductor, but to determine the active power flowing in the conductor, both the voltage and current must be measured simultaneously as active power (or real power) is the product of the voltage and component of current in phase with the voltage. The sign of the active power will indicate the direction of power flow.

US2017/030952 discloses an apparatus and method for handling the heating which results from the operation of a self-powered power sensor. US2010/0301837 discloses a power measuring system.

## Summary of the Invention

The invention provides a system for remotely measuring the active power flowing through an electrical conductor from an alternating current (AC) source to a load as set out in the claims.

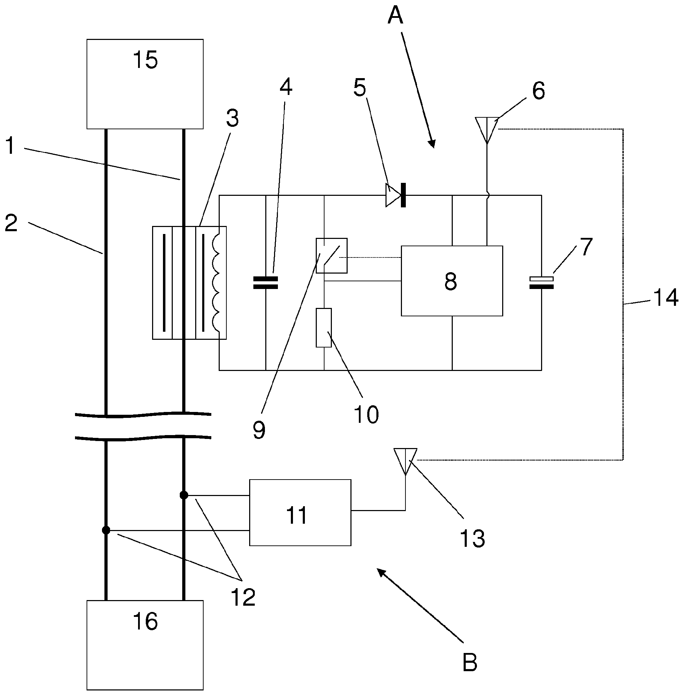

## Brief Description of the Drawing

The drawing is a circuit diagram illustrating in block diagram form a system according to one example of the invention.

## Detailed Description of the Illustrated Embodiment

In the drawing, a first unit A is installed on one of the conductors 1 leading from an AC power source 16 to a load 15. The AC power source 16 is an on-site power generation installation such as solar photovoltaic panels, wind turbines or other renewable energy sources. The load may be the utility grid. The first unit comprises a current transformer 3 mounted around the insulating sheath of the conductor 3 and in close proximity therewith. The current transformer 3 serves two purposes: to harvest energy for the operation of the first unit; and to measure the current in the conductor 1 without electrical contact. In the first of these two modes, a resonator capacitor 4 connected across the transformer 3 resonates with the transformer to create an AC voltage across the capacitor 4 which is then rectified by a diode 5 and accumulated as DC voltage in a reservoir capacitor 7. The inclusion of the resonator capacitor 4 significantly improves energy harvesting, especially when there is only a very small current flowing through the conductor 1.

When there is sufficient voltage across the reservoir capacitor 7, a processor 8 closes a switch 9 to connect a burden resistor 10 in parallel with the current transformer 3. This effectively stops the charging cycle and the processor 8 can then sample the voltage across the burden resistor 10 for a period equal to at least one cycle of the AC voltage, the sampled voltage signal reflecting the current flowing in the primary conductor. A typical sampling rate might be 64 per AC mains cycle, so the process may result in a set of 64 voltage samples - it will be appreciated that other rates and sample sizes may be employed.

The raw voltage samples are then processed by the processor 8 using a Fast Fourier Transform (FFT) to convert the large number of samples to only two values: the real and imaginary parts of the fundamental frequency. Reducing the data in this manner makes it possible to transmit it using only harvested power; it would not be possible to transmit large amounts of data with the limited amount of energy available from the energy harvesting circuit.

If the voltage measured by the second unit B is assumed to be a sine wave with only one frequency component, the FFT results for the harmonic frequencies can be ignored, because the active power is calculated as the sum of the products of all the frequency components of the voltage and current. The processor is thus configured to transmit, via antenna 6 and radio link 14, a signal representing the variables output by the FFT, along with length of time between starting and completing the sampling of the signal, with the subsequent FFT calculations. The radio link can be any suitable low power transmitter/receiver combination operating on

The second unit B comprises a processor 11 including a wireless receiver linked to a receiver antenna 13 to receive the signal transmitted by the first unit A. The processor is connected to the outputs conductors 1 and 2 from the AC power source 16, both to provide the energy for its operation and to measure the voltage output by the source. Since the signal received from the first unit A includes the time data as well as the two variables, the processor 11 'knows' how long ago the current sampling started, as well as the real and imaginary parts of the fundamental frequency of the current waveform. The processor then calculates the amplitude of the current using the following formula:

$$I_{pk} = \sqrt{I_{re}^{\;2} + I_{im}^{\;2}}$$

where:

$I_{pk}$ = amplitude of current
$I_{re}$ = real part of current
$I_{im}$ = imaginary part of current.

The active power is calculated by:

$$P = I_{pk}.V_{pk}.T$$

where:

$I_{pk}$ = amplitude of current
$V_{pk}$ = amplitude of voltage
$T$ = time between start of current sampling and receiving + calculation time.

The sign of the calculated active power will indicate the direction of power flow in the conductor.

**Claims**

1.  A system for remotely measuring the active power flowing through an electrical conductor (1) from an alternating current (AC) source (16) to a load, the system comprising a first unit located on the conductor and a second unit electrically connected to the AC source,

    the first unit comprising a current transformer (3) mounted in close proximity to the conductor (1), storage means (7) for storing energy from the current transformer (3), a processor (8), a wireless transmitter, a resistor (10) and a switch (9) controlled by the processor (8) to selectively switch the resistor (10) in parallel with the current transformer (3), the processor (8) being configured to:

    sample the voltage across the resistor (10) for a predetermined period,
    perform a Fast Fourier Transform on the voltage samples to convert the voltage samples to only two values, being the real and imaginary parts of the fundamental frequency, and
    transmit to the second unit a signal representing the variables output by the Transform,

    and the second unit comprising a receiver (11) to receive the signal from the first unit and being configured to measure the voltage of the AC power source (16) and to calculate from this and the received data the power and direction of electricity flowing in the conductor.

2.  A system according to Claim 1, wherein the storage means (7) comprises a capacitor.

3.  A system according to Claim 1 or 2, wherein the processor (8) in the first unit is configured to transmit with the variables output by the Transform time information relating to the sampling of the voltage.

4.  A system according to Claim 1, 2 or 3, comprising a capacitor connected in parallel with the current transformer (3).

**Patentansprüche**

1.  System zum Messen der Wirkleistung, die aus einer Wechselstrom(AC)-Quelle (16) durch einen elektrischen Leiter (1) zu einer Last fließt, wobei das System eine erste an dem Leiter lokalisierte Einheit und eine zweite Einheit, elektrisch mit der AC-Quelle verbunden, umfasst,

    wobei die erste Einheit einen in nächster Nähe zu dem Leiter (1) montierten Stromtransformator (3), Speichermittel (7) zum Speichern von Energie von dem Stromtransformator (3), einen Prozessor (8), einen drahtlosen Transmitter, einen Widerstand (10) und einen durch den Prozessor (8) gesteuerten Schalter (9) umfasst, um den Widerstand (10) parallel mit dem Stromtransformator (3) zu schalten, wobei der Prozessor (8) konfiguriert ist, um:

    die Spannung über den Widerstand (10) für einen vorher festgelegten Zeitraum abzutasten,
    eine Fast-Fourier-Transformation an den Spannungsabtastungen durchzuführen, um die Spannungsabtastungen in ausschließlich zwei Werte umzuwandeln, die der reale und komplexe Teil der Grundfrequenz sind, und
    ein Signal an die zweite Einheit zu übertragen, das die durch die Transformation ausgegebenen Variablen repräsentiert,

und die zweite Einheit einen Empfänger (11) umfasst, um das Signal von der ersten Einheit zu empfangen, und die konfiguriert ist, um die Spannung der AC-Leistungsquelle (16) zu messen und aus dieser und den empfangenen Daten die Leistung und Richtung von Elektrizität, die in dem Leiter fließt, zu berechnen.

**2.** System nach Anspruch 1, wobei das Speichermittel (7) einen Kondensator umfasst.

**3.** System nach Anspruch 1 oder 2, wobei der Prozessor (8) in der ersten Einheit konfiguriert ist, um mit den durch die Transformation ausgegebenen Variablen Zeitinformationen zu übertragen, die das Abtasten der Spannung betreffen.

**4.** System nach Anspruch 1, 2 oder 3, umfassend einen parallel mit dem Stromtransformator (3) verbundenen Kondensator.

**Revendications**

**1.** Système pour mesurer à distance la puissance active circulant dans un conducteur électrique (1) depuis une source de courant alternatif (CA) (16) jusqu'à une charge, le système comprenant une première unité située sur le conducteur et une seconde unité connectée électriquement à la source de CA,

la première unité comprenant un transformateur de courant (3) monté à proximité immédiate du conducteur (1), un moyen de stockage (7) pour stocker l'énergie provenant du transformateur de courant (3), un processeur (8), un émetteur sans fil, une résistance (10) et un commutateur (9) commandé par le processeur (8) pour commuter sélectivement la résistance (10) en parallèle avec le transformateur de courant (3), le processeur (8) étant configuré pour :

échantillonner la tension aux bornes de la résistance (10) pendant une période prédéterminée,
effectuer une Transformation de Fourier rapide sur les échantillons de tension pour convertir les échantillons de tension en deux valeurs seulement, qui sont les parties réelle et imaginaire de la fréquence fondamentale, et
transmettre à la seconde unité un signal représentant les variables produites par la Transformation,

et la seconde unité comprenant un récepteur (11) pour recevoir le signal de la première unité et étant configurée pour mesurer la tension de la source d'alimentation CA (16) et pour calculer à partir de celle-ci et des données reçues la puissance et la direction de l'électricité circulant dans le conducteur.

**2.** Système selon la revendication 1, dans lequel le moyen de stockage (7) comprend un condensateur.

**3.** Système selon la revendication 1 ou 2, dans lequel le processeur (8) dans la première unité est configuré pour transmettre avec les variables produites par la Transformation des informations de temps relatives à l'échantillonnage de la tension.

**4.** Système selon la revendication 1, 2 ou 3, comprenant un condensateur connecté en parallèle avec le transformateur de courant (3).

**EP 3 486 665 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017030952 A
- US 20100301837 A